# EUROPEAN PATENT SPECIFICATION

(11) **EP 0 517 408 B1**
(45) Date of publication and mention of the grant of the patent: **21.07.2004**
(21) Application number: 92304719.5
(22) Date of filing: 26.05.1992
(51) Int. Cl.: H01L 21/82, H01L 27/11

(54) **Sram cell and structure with polycrystalline p-channel load devices**
Sram-Zelle und Struktur, beinhaltend polykristalline Lastelemente mit P-leitendem Kanal
Cellule et structure Sram avec des dispositifs de charge polycristallins à canal p

(30) Priority: 03.06.1991 US 709630; 03.06.1991 US 709354
(43) Date of publication of application: 09.12.1992
(73) Proprietor: STMicroelectronics, Inc., Carrollton, TX 75006-5039 (US)
(72) Inventor: Chan, Tsui C., Carrollton, Texas 75006 (US); Bryant, Frank R., Denton, Texas 76201 (US); Jorgenson, Lisa K., Coleyville, Texas 76034 (US)
(74) Representative: Palmer, Roger

(56) References cited:
- EP-A- 0 173 245
- EP-A- 0 297 350
- INTERNATIONAL ELECTRON DEVICES MEETING December 1988, SAN FRANCISCO, CA, USA pages 48 - 51; T. YAMANAKA ET AL.: 'A 25 um2 NEW POLY-SI PMOS LOAD (PPL) SRAM CELL HAVING EXCELLENT SOFT ERROR IMMUNITY'

## Description

The present invention relates generally to semiconductor integrated circuit processing, and more specifically to a SRAM cell and structure with polycrystalline p-channel load device without series diodes.

CMOS static random access memories (SRAM) are increasingly used in the semiconductor industry due to their combination of speed, low power and no requirement for refresh. Information can be written into and read out of a SRAM cell faster than with a DRAM cell because the transistors of the SRAM cell can be switched faster than capacitors can be charged and drained. The trade-off, however, to achieve greater speed and less volatility is that the SRAM cell is less dense requiring more space.

The basic SRAM cell can be formed using cross-coupled CMOS inverters having 2 each N-channel and P-channel transistors. The cell is accessed by, typically, 2 N-channel control gates for a standard SRAM cell and 4 control gates for 2-port memory devices. To conserve physical layout space, the P-channel transistors are often replaced with resistive loads.

Use of the P-channel transistors as the load for the SRAM cell, however, results in the cell having better electrical characteristics. Such cells are faster than those using resistive loads, since the P-channel transistors provide a higher drive current than high resistance devices. Also, use of P-channel transistors gives higher immunity to soft errors, such as those caused by alpha particle impacts and noise. The primary disadvantage of SRAM cells incorporating P-channel load transistors is that the layout area for each cell is significantly larger than those using resistive loads. This reduces device density and increases chip costs.

A disadvantage of using polycrystalline P-channel load transistors arises where ohmic contact is required between the interconnection of P-channel and N-channel transistors. Ohmic contact between interconnect layers is desirable because no P-N junction is formed. A P-N junction is formed, however, where polycrystalline interconnect lines having different conductivity types make contact. A similar junction can be formed when polycrystalline silicon lines having the same conductivity type, but very different doping levels (such as N⁻⁻ to N+ ) make contact.

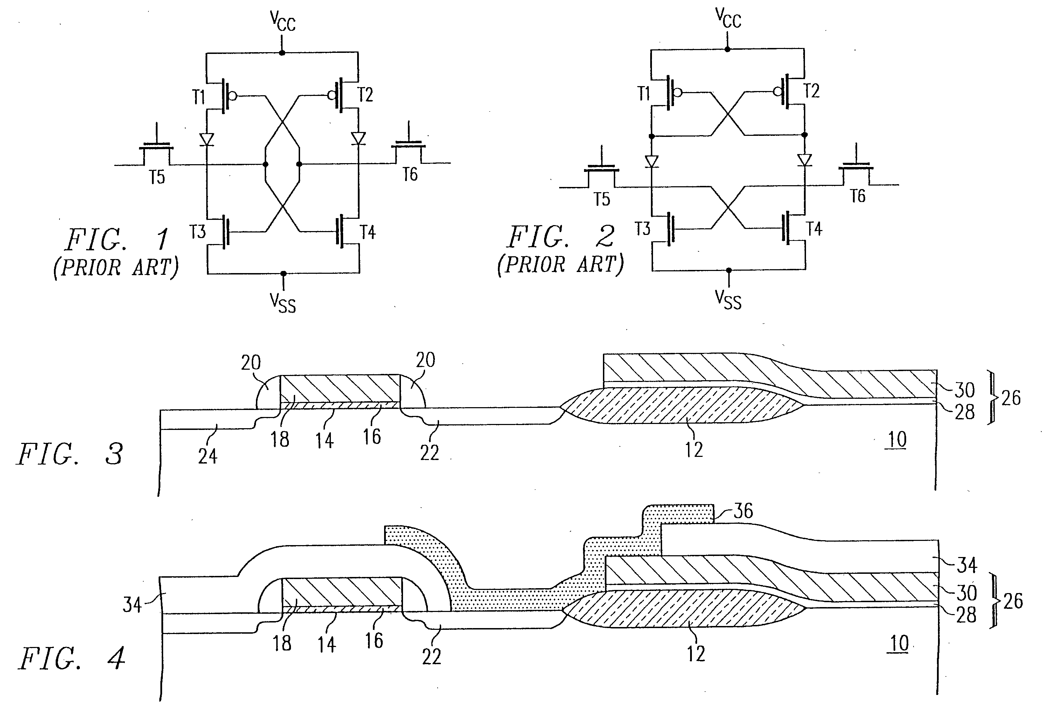

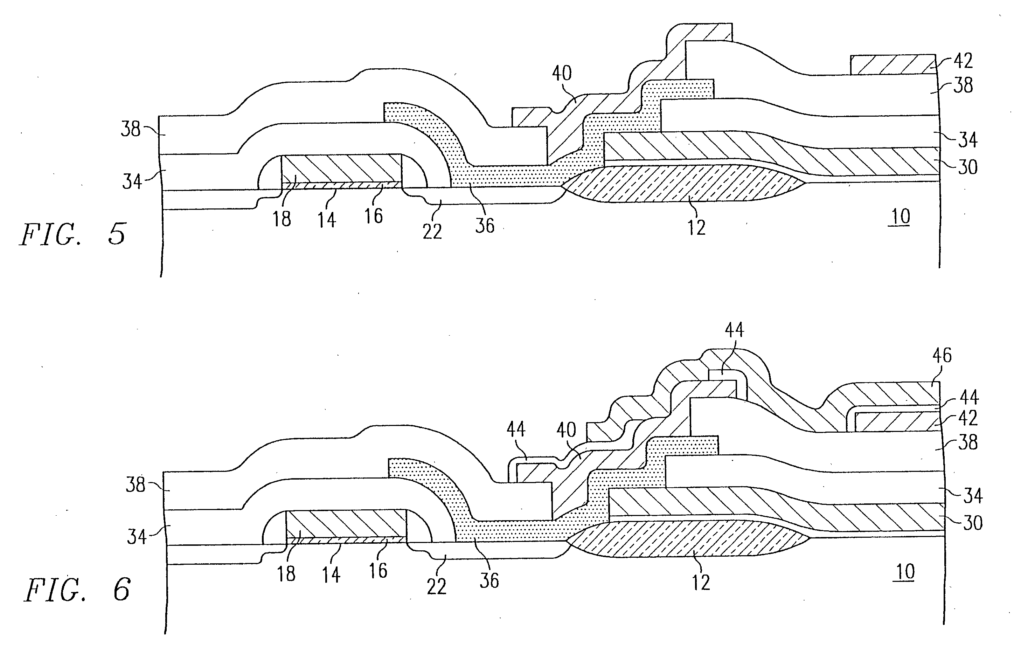

In the prior art, as shown in Figures 1 and 2, for example, where P-channel transistors are used as the load devices, a junction diode will be formed at the location where a polycrystalline P-channel transistor contacts a N-channel transistor. As shown in Figure 1, if the polycrystalline P-channel transistor T1 has a gate electrode made of a N-type conductivity polycrystalline silicon, a P-N junction or junction diode will be formed between the P+ source/drain region of the P-channel transistor and its N+ gate which connects to the source/drain region of the N-channel transistor T3. As shown in Figure 2, if the conductivity type of the gate of the P-channel transistor is P-type, a junction diode will be formed between the P-channel gate electrode of T1 and the N+ source/drain region of the N-channel transistor T4.

It would be desirable to use P-channel transistors as the load devices in an SRAM cell while preventing a junction diode from forming between P-channel and N-channel transistors. It would be desirable to use a conductive material as an interconnect at the shared contact areas between the P- and N-channel devices to prevent a junction diode from forming.

'A 25 µm² New Poly-Si PMOS Load (PPL) SRAM Cell having excellent soft error immunity' in 'The Electron Device Meeting', December 1988, San Francisco pages 48-51, discloses the formation of a conductive interconnect over an N-type source/drain region to electrically connect it to an overlying P-type third polysilicon layer via an N-type second polysilicon layer. EP-A-0173245 discloses the use of a metal, for example tungsten, or a metal silicide for ohmically contacting high resistance polycrystalline silicon to low resistance single crystal silicon and for preventing the diffusion of impurities from the silicon into the polysilicon. Neither of these references disclose arrangements for avoidance of diode formation.

EP-A-0297350 discloses the method of silicidation at a via opening to short out a P+/N+ diode.

It is an object of the present invention to provide a method and structure for the formation of a semiconductor device which may reduce the problem of diode formation at an interlayer connection.

Therefore, according to the present invention, a method is provided for producing a semiconductor device structure with polycrystalline p-channel load devices of an integrated circuit comprising the steps of: providing a first n-channel field effect device; providing a first insulating layer disposed over the n-channel field effect device with an opening to expose an underlying conductive structure comprising at least a portion of a n-type source/drain region of said n-channel field effect device; providing a contact layer over the exposed underlying conductive structure defining a portion of a shared contact region, said contact layer making electrical contact with said source/drain region of said n-channel field effect device; providing a first p-type polysilicon layer comprising a first gate electrode of a first p-channel field effect device disposed over a portion of the first insulating layer; providing a first gate oxide layer; and providing a second polysilicon layer, comprising the source/drain region and channel region of the first p-channel field effect device, disposed over the first gate electrode of the first p-channel field effect device and the contact layer, said source/drain region of said p-channel device having p-type conductivity, characterised in that said first p-type polysilicon layer also comprises a region in contact with said contact layer, said gate oxide layer being disposed over the first gate electrode of the first p-channel field effect device and said region of said first p-type polysilicon layer in contact with said contact layer, and in that the source/drain region of the p-channel device makes electrical contact with the underlying conductive structure through said region of said first p-type polysilicon layer and said contact layer and wherein said contact layer is formed frommaterials selected from the group comprising metal; metal silicide; n-type polysilicon overlaid with a metal silicide; and silicide overlaid with p-type polysilicon.

According to another aspect of the present invention there is provided a structure consisting of a portion of a semiconductor integrated circuit comprising: a first n-channel field effect device; a first insulating layer disposed over the n-channel field effect device with an opening to expose an underlying conductive structure comprising at least a portion of the n-type source/drain region of said n-channel field effect device; a contact layer over the exposed underlying conductive structure defining a portion of a shared contact region, said contact layer making electrical contact with said source/drain region of said n-channel field effect device; a first p-type polysilicon layer comprising a first gate electrode of a first p-channel field effect device disposed over a portion of the first insulating layer; a first gate oxide layer; and a second polysilicon layer, comprising the source/drain region and channel region of the first p-channel field effect device, disposed over the first gate electrode of the first p-channel field effect device and the contact layer, said source/drain region of said p-channel device having p-type conductivity, characterised in that said first p-type polysilicon layer also comprises a region in contact with said contact layer, said gate oxide layer being disposed over the first gate electrode of the first p-channel field effect device and said region of said first p-type polysilicon layer in contact with said contact layer, and in that the source/drain region of the p-channel device makes electrical contact with the underlying conductive structure through said region of said first p-type polysilicon layer and said contact layer, and wherein said contact layer is formed from material selected from the group comprising: metal; metal silicide; n-type polysilicon overlaid with a metal silicide; and silicide overlaid with p-type polysilicon.

The novel features believed characteristic of the invention are set forth in the appended claims. The invention itself, however, as well as a preferred mode of use, and advantages thereof, will best be understood by reference to the following detailed description of an illustrative embodiment when read in conjunction with the accompanying drawings, wherein:
Figures 1-2 illustrate a schematic representation of the SRAM prior art circuit.
Figures 3, 4, 4a, 5, 5a, 6 and 6a illustrate alternative preferred methods for fabricating a semiconductor device structure, according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to Figure 3, an integrated circuit device is to be formed in a silicon substrate 10. Selected regions of the substrate 10 are oxidized to form a field oxide insulating region 12. A first N-channel field effect device 14 having a gate oxide layer 16, a first gate electrode 18, sidewall oxide spacers 20 and source/drain regions 22, 24 are manufactured by methods known in the art. Gate electrode 18 is generally formed from a first polycrystalline silicon layer, such as commonly used to form gate electrodes or field effect devices. A second N-channel field effect device 26 is formed by methods known in the art having a gate oxide layer 28 and a second gate electrode 30. As with the first N-channel field effect device 14, the second N-channel field effect device 26 is generally formed from a first polycrystalline silicon layer. The source/drain region 22 of device 14 and the gate electrode 30 form the interconnected conductive structures of the N-channel devices.

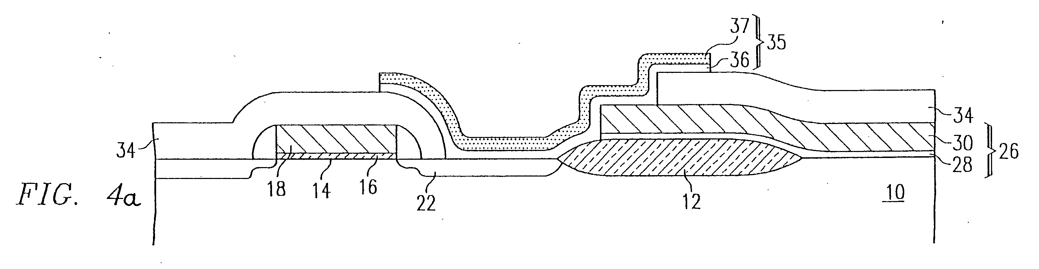

Referring to Figures 4 and 4a, a first oxide insulating layer 34 is formed over the integrated circuit by known methods. Insulating layer 34 is patterned and etched to expose a portion of the underlying conductive structure source/drain region 22 of device 14. A portion of the second gate electrode 30 of the second N-channel device 26 may also be exposed during the patterning and etching steps. Source/drain region 22 and gate electrode 30 of the first and second N-channel field effect devices respectively are typically implanted with a N+ type dopant such as arsenic or phosphorus.

Device fabrication up to this stage utilizes conventional process steps well known in the art. Historically, the SRAM cell is built with all N-channel and P-channel field effect devices or transistors being formed in the substrate. In order to increase packing density while maintaining better electrical characteristics using P-channel transistors as load devices, the P-channel transistors in the present invention are stacked above the N-channel transistors.

Referring to Figure 4, a metal containing layer 36 is deposited over the surface of the integrated circuit. Layer 36 is preferably a refractory metal or a refractory metal silicide such as tantalum or tantalum silicide respectively. Metal layer 36 is deposited by sputtering. The metal containing layer 36 is then patterned and etched by methods known in the art to form a shared contact region disposed over the exposed portions of source/drain region 22. Layer 36 will also be disposed over a portion of gate electrode 30 if gate 30 was exposed during the patterning and etching process of the first insulating layer 34.

In the alternative embodiment shown in Figure 4a, an interconnect layer 35 containing a doped polysilicon layer 36 and a barrier layer 37 is formed over the surface of the integrated circuit. Polysilicon layer 36 is first deposited, then barrier layer 37 is deposited. The interconnect layer 35 is then patterned and etched by methods known in the art to form a shared contact region disposed over the exposed portions of source/drain region 22. Layer 35 will also be disposed over a portion of gate electrode 30 if gate 30 was exposed during the patterning and etching process of the first insulating layer 34. Polysilicon layer 36 is implanted with a N-type dopant. Barrier layer 37 is preferably a silicide.

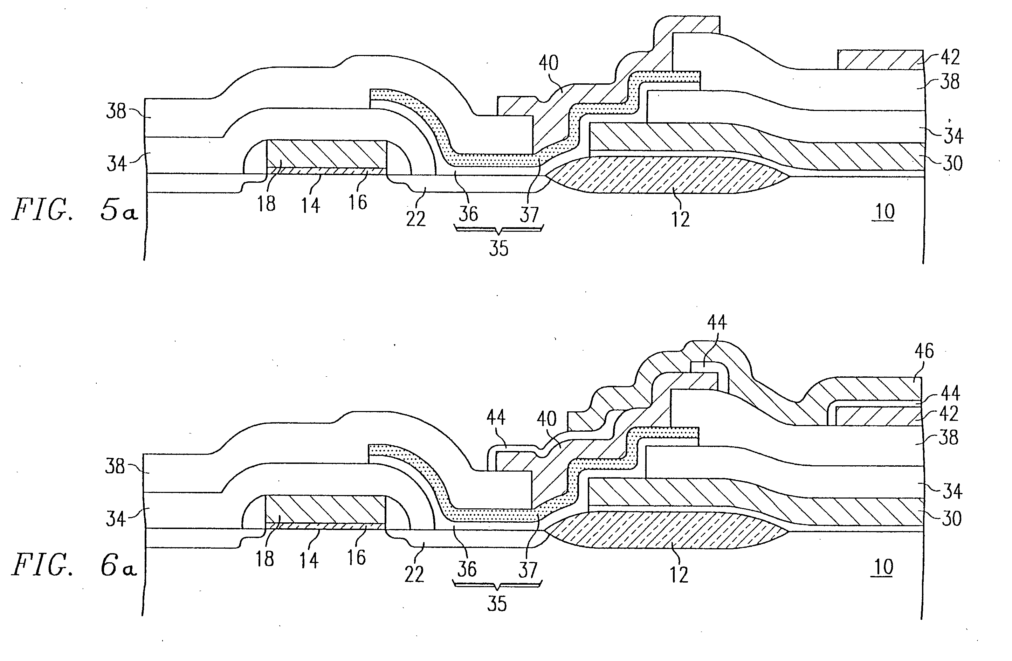

Referring to Figures 5 and 5a, a second oxide insulating layer 38 may be formed over the integrated circuit, if necessary. Insulating layer 38, if formed, is then patterned and etched by methods known in the art to expose a portion of the metal containing layer 36. A first conductive layer is then deposited over the integrated circuit. The first conductive layer is then patterned and etched to define a first gate electrode 42 of a first P-channel field effect device. Alternatively, a second gate electrode 40 of a second P-channel field effect device may also be defined from the first conductive layer. The first conductive layer is typically a doped polysilicon. Thus, gate electrode 40 and gate electrode 42, if formed, are typically implanted with a P+ type dopant such as boron or boron diflouride.

In the embodiment shown in Figure 5, if gate electrode 40 is formed, metal container layer 36 is now a shared contact between gate electrode 40 of the second P-channel device and the source/drain region 22 of the first N-channel device. Metal containing layer 36 will also connect gate 30 of the second N-channel device to source/drain region 22 and gate electrode 40 if a portion of gate 30 was exposed. If gate 30 is not connected to metal layer 36, it will connect to source/drain region 22 elsewhere (not shown).

In the alternative embodiment shown in Figure 5a, if gate electrode 40 is formed, interconnect layer 35 is now a shared contact between gate electrode 40 of the second P-channel device and the source/drain region 22 of the first N-channel device. Interconnect layer 35 will also connect gate 30 of the second N-channel device to source/drain region 22 and gate electrode 40 if a portion of gate 30 was exposed. If gate 30 is not connected to the interconnect layer 35, it will connect to source/drain region 22 elsewhere (not shown). Polysilicon layer 36 may be implanted alternatively with a P-type dopant. In this case, polysilicon layer 36 will be disposed over the barrier layer 37 to form the shared contact.

Referring to Figures 6 and 6a, a gate oxide layer 44 is grown over the first gate electrode 42 of the first P-channel device and over the second gate electrode 40 of the second P-channel device, if formed. If the second gate electrode 40 is formed, the gate oxide layer 44 will be etched to expose a portion of the second gate 40.

A second conductive layer 46 is deposited over the integrated circuit and patterned and etched to form a source/drain and channel region of the first gate electrode 42 of the first P-channel field effect device. The second conductive layer will be disposed over the gate oxide covering gate 42 and the exposed portion of gate 40 if gate 40 is formed. The second conductive layer 46 is typically a doped polysilicon layer, lightly implanted with a N-type dopant in the channel region directly over gate 42 and heavily implanted with a P+ type dopant such as boron in the source/drain region.

Referring to Figure 6, if gate electrode 40 is formed, metal containing layer 36 is now a shared contact between gate electrode 40 of the second P-channel device, the source/drain region 22 of the first N-channel device and the source/drain and channel region 46 of the gate electrode 42. If gate electrode 40 is not formed on top of metal containing layer 36 as shown, it will be connected to layer 36 elsewhere such as beside layer 36 coming out from the plane of the drawing as shown in Figure 5 and 6 or it will be connected to layer 36 via layer 46. Metal containing layer 36 will also connect gate 30 of the second N-channel device to source/drain region 22 and gate electrode 40 if a portion of gate 30 was exposed. The metal containing layer is then a shared contact between two N-channel and two P-channel field effect devices in a six transistor SRAM cell. The shared contact is now connecting materials having different conductivity types.

Connecting P-channel and N-channel field effect devices together requires connecting materials of different conductivity types, typically resulting in the formation of P-N junctions. Using a metal or a metal silicide interconnect layer as a shared contact between N-channel and P-channel transistors will prevent a P-N junction from forming. If no P-N junction is formed, the series diodes, as depicted in the prior art Figures 1 and 2, will not form and a good ohmic contact will be made between these devices.

Referring to the alternative embodiment of Figure 6a, if gate electrode 40 is formed, the interconnect layer 35 is now a shared contact between gate electrode 40 of the second P-channel device, the source/drain region 22 of the first N-channel device and the source/drain and channel region 46 of the gate electrode 42. If the gate electrode 40 is not formed on top of the interconnect layer 35 as shown, it will be connected to layer 35 elsewhere such as beside layer 35 coming out from the plane of the drawing as shown in Figures 5a and 6a or it will be connected to layer 35 via layer 46. The interconnect layer 35 will also connect gate 30 of the second N-channel device to source/drain region 22 and gate electrode 40 if a portion of gate 30 was exposed. The interconnect layer is then a shared contact between two N-channel and two P-channel field effect devices in a six transistor SRAM cell. The shared contact is now connecting materials having different conductivity types.

Connecting P-channel and N-channel field effect devices together requires connecting materials of different conductivity types, typically resulting in the formation of P-N junctions. Using a doped polysilicon layer with a barrier layer such as a refractory metal silicide as an interconnect layer or a shared contact between N-channel and P-channel transistors will prevent a P-N junction from forming. With the barrier layer disposed between the different polysilicon having different conductivity types, no P-N junction is formed and the series diodes, as depicted in the prior art Figures 1 and 2, will not form. A good ohmic contact will thus be made between these devices.

While the invention has been particularly shown and described with reference to a preferred embodiment, it will be understood by those skilled in the art that various changes in form and details may be made within the scope of the claims.

## Claims

1. A method of producing a semiconductor device structure with polycrystalline p-channel load devices of an integrated circuit comprising the steps of: providing a first n-channel field effect device (14); providing a first insulating layer (34) disposed over the n-channel field effect device with an opening to expose an underlying conductive structure comprising at least a portion of a n-type source/drain region of said n-channel field effect device; providing a contact layer (35;36) over the exposed underlying conductive structure defining a portion of a shared contact region, said contact layer making electrical contact with said source/drain region (22) of said n-channel field effect device; providing a first p-type polysilicon layer (40,42) comprising a first gate electrode (42) of a first p-channel field effect device disposed over a portion of the first insulating layer (34); providing a first gate oxide layer (44); and providing a second polysilicon layer (46), comprising the source/drain region and channel region of the first p-channel field effect device, disposed over the first gate electrode (42) of the first p-channel field effect device and the contact layer (35;36), said source/drain region of said p-channel device having p-type conductivity, **characterised in that**:
said first p-type polysilicon layer (40,42) also comprises a region (40) in contact with said contact layer (35;36), said gate oxide layer (44) being disposed over the first gate electrode (42) of the first p-channel field effect device and said region (40) of said first p-type polysilicon layer in contact with said contact layer (35;36), and **in that** the source/drain region of the p-channel device makes electrical contact with the underlying conductive structure through said region (40) of said first p-type polysilicon layer and said contact layer (35;36) and
wherein said contact layer is formed from materials selected from the group comprising metal; metal silicide; n-type polysilicon overlaid with a metal silicide; and silicide overlaid with p-type polysilicon.

2. The method of claim 1, further comprising, before the step of forming the first insulating layer (34) over a substrate (10), the steps of:
forming a field oxide region (12) over a portion of the substrate;
forming source/drain regions in the substrate;
forming the first gate electrode (18) of said first n-channel field effect device (14) over the substrate and forming a second gate electrode (30) of a second n-channel field effect device (26) over a portion of the field oxide region (12) and the substrate (10);
whereby the underlying conductive structure is formed from a portion of the source/drain region (22) of the first n-channel field effect device and a portion of the second gate electrode (30) of the second n-channel field effect device.

3. The method of any preceding claim further comprising, after the step of providing the contact layer (35,36), the steps of:
forming a second insulating layer (38) over the integrated circuit; and
patterning and etching the second insulating layer (38) to expose a portion of the contact layer (35,36),
wherein at the same time as the first p-type polysilicon layer is patterned and etched to define the first gate electrode (42) of the first p-channel field effect device, the first p-type polysilicon layer is also patterned and etched to define a second gate electrode (40) of a second p-channel field effect device.

4. The method of claim 3, further comprising the step of:
forming the gate oxide layer (44) over the second gate electrode of the second p-channel field effect device at the same time the gate oxide layer (44) is formed over the first gate electrode (42) of the first p-channel device.

5. The method of any preceding claim when dependent upon claim 3 wherein the first p-type polysilicon layer (40,42) and the portion of the second polysilicon layer (46) in contact therewith are doped with a P+ type dopant.

6. The method of any preceding claim when dependent upon claim 2 wherein the source/drain region of the first n-channel field effect device and the second gate electrode of the second n-channel field effect device are doped with a N+ type dopant.

7. The method of any preceding claim wherein the metal material of the contact layer (36) is refractory metal.

8. The method of any preceding claim wherein the metal silicide of the contact layer is refractory metal silicide.

9. The method of any preceding claim wherein, in the contact layer, the silicide layer formed in combination with the doped polysilicon layer is a refractory metal silicide.

10. The method of any preceding claim wherein said step of forming said contact layer comprises sputter depositing metal.

11. A structure consisting of a portion of a semiconductor integrated circuit comprising: a first n-channel field effect device (14); a first insulating layer (34) disposed over the n-channel field effect device with an opening to expose an underlying conductive structure comprising at least a portion of the n-type source/drain region of said n-channel field effect device; a contact layer (35;36) over the exposed underlying conductive structure defining a portion of a shared contact region, said contact layer making electrical contact with said source/drain region (22) of said n-channel field effect device; a first p-type polysilicon layer (40;42) comprising a first gate electrode (42) of a first p-channel field effect device disposed over a portion of the first insulating layer (34); a first gate oxide layer (44); and a second polysilicon layer (46), comprising the source/drain region and channel region of the first p-channel field effect device, disposed over the first gate electrode (42) of the first p-channel field effect device and the contact layer (35;36), said source/drain region of said p-channel device having p-type conductivity, **characterised in that**:
said first p-type polysilicon layer (40,42) also comprises a region (40) in contact with said contact layer (35;36), said gate oxide layer (44) being disposed over the first gate electrode (42) of the first p-channel field effect device and said region (40) of said first p-type polysilicon layer in contact with said contact layer (35;36); and **in that** the source/drain region of the p-channel device makes electrical contact with the underlying conductive structure through said region (40) of said first p-type polysilicon layer and said contact layer (35;36), and
wherein said contact layer is formed from material selected from the group comprising: metal; metal silicide; n-type polysilicon overlaid with a metal silicide; and silicide overlaid with p-type polysilicon.

12. The structure of claim 11 wherein the underlying conductive structure is the source/drain region (22) of the first n-channel field effect device and a second gate electrode (30) of a second n-channel field effect device, and wherein said source/drain region is in the substrate and the second gate electrode is disposed over a field oxide region and the substrate.

13. The structure of claim 12, wherein the source/drain region (22) of the first n-channel field effect device and the second gate electrode (30) of the second n-channel field effect device are doped with a N+ type dopant.

14. The structure of any one of claims 11 to 13, further comprising:
a second insulating layer (38), disposed over the contact layer (35,36) and the first insulating layer (34), having an opening exposing a portion of the contact layer (35,36);
the region (40) of said first p-type polysilicon layer comprising a second gate electrode of a second p-channel field effect device formed from a p-type doped second polysilicon layer, disposed over the contact layer (35,36) and a portion of the second insulating layer (38).

15. The structure of any one of claims 11 to 14, wherein the metal contact layer is a refractory metal layer.

16. The structure of any one of claims 11 to 15, wherein the metal silicide contact layer is a refractory metal silicide.

17. The structure of claim 14, wherein the second polysilicon layer (46) and a portion of the first p-type polysilicon layer (40,42) are in physical contact and are P+ type doped.

## Patentansprüche

1. Verfahren zur Erzeugung einer Halbleitervorrichtungsstruktur mit polykristallinen Ladeeinrichtungen mit p-Kanal einer integrierten Schaltung, das die Schritte aufweist: eine erste Feldeffekteinrichtung (14) mit n-Kanal wird zur Verfügung gestellt; eine erste isolierende Schicht (34) wird vorgesehen, die über der Feldeffekteinrichtung mit n-Kanal mit einer Öffnung angeordnet ist, um eine darunter liegende leitende Struktur freizulegen, die zumindest einen Abschnitt eines Source-/Drainbereiches vom n-Typ der Feldeffekteinrichtung mit n-Kanal aufweist; eine Kontaktschicht (35; 36) wird über der freigelegten, darunter liegenden leitenden Struktur, die einen Abschnitt eines aufgeteilten Kontaktbereiches festlegt, vorgesehen, wobei die Kontaktschicht einen elektrischen Kontakt zu dem Source-/Drainbereich (22) der Feldeffekteinrichtung mit n-Kanal herstellt; eine erste Polysilizium-Schicht (40, 42) vom p-Typ wird vorgesehen, die eine erste Gate-Elektrode (42) und eine erste Feldeffekteinrichtung mit p-Kanal, die über einem Abschnitt der ersten isolierenden Schicht (34) angeordnet ist, aufweist; eine erste Gateoxid-Schicht (44) wird vorgesehen; und eine zweite Polysilizium-Schicht (46) wird vorgesehen, die den Source-/Drainbereich und den Kanalbereich der ersten Feldeffekteinrichtung mit p-Kanal aufweist, die über der ersten Gate-Elektrode (42) der ersten Feldeffekteinrichtung mit p-Kanal und der Kontaktschicht (35; 36) angeordnet ist, wobei der Source-/Drainbereich der Einrichtung mit p-Kanal eine Leitfähigkeit vom p-Typ hat, **dadurch gekennzeichnet, dass**:
die erste Polysilizium-Schicht (40, 42) vom p-Typ auch einen Bereich (40) aufweist, der in Kontakt zu der Kontaktschicht (35; 36) ist, wobei die Gateoxid-Schicht (44) über der ersten Gate-Elektrode (42) der ersten Feldeffekteinrichtung mit p-Kanal und dem Bereich (40) der ersten Polysilizium-Schicht vom p-Typ angeordnet ist, die in Kontakt zu der Kontaktschicht (35; 36) ist, und dadurch, dass der Source-/Drainbereich der Einrichtung mit p-Kanal einen elektrischen Kontakt zu der darunter liegenden leitenden Schicht über den Bereich (40) der ersten Polysilizium-Schicht vom p-Typ und die Kontaktschicht (35; 36) herstellt, und wobei die Kontaktschicht aus Materialien ausgebildet ist, die aus der Gruppe ausgewählt sind, die aufweist, Metall; Metallsilizid; Polysilizium vom n-Typ, bedeckt bzw. überzogen mit einem Metallsilizid; und ein Silizid, das mit Polysilizium vom p-Typ bedeckt bzw. überzogen ist.

2. Verfahren nach Anspruch 1, das vor dem Schritt zur Ausbildung der ersten isolierenden Schicht (34) über einem Substrat (10) die Schritte aufweist:
ein Feldoxidbereich (12) wird über einem Abschnitt des Substrats ausgebildet;
Source-/Drainbereiche werden in dem Substrat ausgebildet;
die erste Gate-Elektrode (18) der ersten Feldeffekteinrichtung (14) mit n-Kanal wird über dem Substrat ausgebildet und eine zweite Gate-Elektrode (30) einer zweiten Feldeffekteinrichtung (26) mit n-Kanal wird über einem Abschnitt des ersten Feldoxidbereiches (12) und dem Substrat (10) ausgebildet;
wodurch die darunter liegende leitende Struktur aus einem Abschnitt des Source/Drainbereiches (22) der ersten Feldeffekteinrichtung mit n-Kanal und einem Abschnitt der zweiten Gate-Elektrode (30) der zweiten Feldeffekteinrichtung mit n-Kanal ausgebildet wird.

3. Verfahren nach einem der voranstehenden Ansprüche, das nach dem Schritt zur Bereitstellung der Kontaktschicht (35, 36) die Schritte aufweist:
eine zweite isolierende Schicht (38) wird über der integrierten Schaltung ausgebildet; und
die zweite isolierende Schicht (38) wird strukturiert und geätzt, um einen Abschnitt der Kontaktschicht (35, 36) freizugeben,
wobei zu der gleichen Zeit, wenn die erste Polysilizium-Schicht vom p-Typ strukturiert und geätzt wird, um die erste Gate-Elektrode (42) der ersten Feldeffekteinrichtung mit p-Kanal festzulegen, die erste Polysilizium-Schicht vom p-Typ auch strukturiert und geätzt wird, um eine zweite Gate-Elektrode (40) einer zweiten Feldeffekteinrichtung vom p-Kanal festzulegen.

4. Verfahren nach Anspruch 3, das ferner den Schritt aufweist:
die Gateoxid-Schicht (44) wird über der zweiten Gate-Elektrode der zweiten Feldeffekteinrichtung mit p-Kanal zu der gleichen Zeit ausgebildet, zu der die Gateoxid-Schicht (44) über der ersten Gate-Elektrode (42) der ersten Einrichtung mit p-Kanal ausgebildet wird.

5. Verfahren nach einem der voranstehenden Ansprüche, wenn diese von Anspruch 3 abhängen, wobei die erste Polysilizium-Schicht (40, 42) vom p-Typ und der Abschnitt der zweiten Polysilizium-Schicht (46), die damit in Kontakt ist, mit einem Dotiermittel vom Typ P+ dotiert werden.

6. Verfahren nach einem der voranstehenden Ansprüche, wenn diese von Anspruch 2 abhängen, wobei der Source-/Drainbereich der ersten Feldeffekteinrichtung mit n-Kanal und die zweite Gate-Elektrode der zweiten Feldeffekteinrichtung mit n-Kanal mit einem Dotiermittel vom Typ N + dotiert werden.

7. Verfahren nach einem der voranstehenden Ansprüche, wobei das Metallmaterial der leitenden Schicht (36) ein hochwiderstandsfähiges Metall bzw. ein Metall, das bei hohen Temperaturen schmilzt, ist.

8. Verfahren nach einem der voranstehenden Ansprüche, wobei das Metallsilizid der leitenden Schicht ein hochwiderstandsfähiges bzw. bei hohen Temperaturen schmelzendes Metallsilizid ist.

9. Verfahren nach einem der voranstehenden Ansprüche, wobei in der Kontaktschicht die Silizidschicht, die in Kombination mit der dotierten Polysilizium-Schicht ausgebildet wird, ein hochwiderstandsfähiges bzw. bei hohen Temperaturen schmelzendes Metallsilizid ist.

10. Verfahren nach einem der voranstehenden Ansprüche, wobei der Schritt zum Ausbilden der Kontaktschicht ein durch Sputtern abgeschiedenes Metall aufweist.

11. Aufbau, der aus einem Abschnitt einer integrierten Halbleiterschaltung besteht, der aufweist: eine erste Feldeffekteinrichtung (14) mit n-Kanal; eine erste isolierende Schicht (34), die über der Feldeffekteinrichtung mit n-Kanal mit einer Öffnung angeordnet ist, um eine darunter liegende leitende Struktur freizulegen, die zumindest einen Abschnitt eines Source-/Drainbereiches vom n-Typ der Feldeffekteinrichtung mit n-Kanal aufweist; eine Kontaktschicht (35; 36) über dem freigelegten, darunter liegenden leitenden Aufbau, der einen Abschnitt eines aufgeteilten Kontaktbereiches festlegt, wobei die Kontaktschicht einen elektrischen Kontakt zu dem Source-/Drainbereich (22) der Feldeffekteinrichtung vom n-Kanal herstellt; eine erste Polysilizium-Schicht (40; 42) vom p-Typ, die eine erste Gate-Elektrode (42) einer ersten Feldeffekteinrichtung mit p-Kanal aufweist, die über einem Abschnitt der ersten isolierenden Schicht (34) angeordnet ist; eine erste Gateoxid-Schicht (44); und eine zweite Polysilizium-Schicht (46), die den Source-/Drainbereich und den Kanalbereich der ersten Feldeffekteinrichtung mit p-Kanal aufweist, die über der ersten Gate-Elektrode (42) der ersten Feldeffekteinrichtung mit p-Kanal und der Kontaktschicht (35; 36) angeordnet ist, wobei der Source-/Drainbereich der Einrichtung mit p-Kanal eine Leitfähigkeit vom p-Typ hat, **dadurch gekennzeichnet, dass**:
die erste Polysilizium-Schicht (40, 42) vom p-Typ auch einen Bereich (40) aufweist, der in Kontakt zu der Kontaktschicht (35; 36) ist, wobei die Gateoxid-Schicht (44) über der ersten Gate-Elektrode (42) der ersten Feldeffekteinrichtung vom p-Kanal und dem Bereich (40) der ersten Polysilizium-Schicht vom p-Typ angeordnet ist, die in Kontakt zu der Kontaktschicht (35; 36) ist; und dadurch, dass der Source-/Drainbereich der Einrichtung mit p-Kanal einen elektrischen Kontakt zu der darunter liegenden leitenden Struktur über den Bereich (40) der ersten Polysilizium-Schicht vom p-Typ und der Kontaktschicht (35; 36) herstellt, und wobei die Kontaktschicht aus einem Material ausgebildet ist, das aus der Gruppe ausgewählt ist, die aufweist: Metall; Metallsilizid; Polysilizium vom n-Typ, bedeckt bzw. überzogen mit einem Metallsilizid; und ein Silizid, das mit einem Polysilizium vom p-Typ bedeckt bzw. überzogen ist.

12. Aufbau nach Anspruch 11, wobei der darunter liegende leitende Aufbau bzw. die darunter liegende leitende Struktur der Source-/Drainbereich (22) der ersten Feldeffekteinrichtung mit n-Kanal und eine zweite Gate-Elektrode (30) einer zweiten Feldeffekteinrichtung mit n-Kanal ist, und wobei der Source-/Drainbereich in dem Substrat ist und die zweite Gate-Elektrode über einem Feldoxidbereich und dem Substrat angeordnet ist.

13. Aufbau nach Anspruch 12, wobei der Source-/Drainbereich (22) der ersten Feldeffekteinrichtung mit n-Kanal und die zweite Gate-Elektrode (30) der zweiten Feldeffekteinrichtung mit n-Kanal mit einem Dotiermittel vom Typ N+ dotiert sind.

14. Aufbau bzw. Struktur nach irgendeinem der Ansprüche 11 bis 13, der bzw. die ferner aufweist:
eine zweite isolierende Schicht (38), die über der Kontaktschicht (35, 36) und der ersten isolierenden Schicht (34) angeordnet ist, die eine Öffnung hat, die einen Abschnitt der leitenden Schicht (35, 36) freigibt;
der Bereich (40) der ersten Polysilizium-Schicht vom p-Typ weist eine zweite Gate-Elektrode einer zweiten Feldeffekteinrichtung mit p-Kanal auf, die aus einer zweiten Polysilizium-Schicht, die p-typ-dotiert ist, ausgebildet ist, die über der Kontaktschicht (35, 36) und einem Abschnitt der zweiten isolierenden Schicht (38) angeordnet ist.

15. Aufbau bzw. Struktur nach irgendeinem der Ansprüche 11 bis 14, wobei die Metallkontaktschicht eine Schicht aus einem hochwiderstandsfähigen bzw. bei hoher Temperatur schmelzenden Metall ist.

16. Aufbau bzw. Struktur nach irgendeinem der Ansprüche 11 bis 15, wobei die Kontaktschicht aus Metallsilizid ein hochwiderstandsfähiges Metallsilizid bzw. ein bei hohen Temperaturen schmelzendes Metallsilizid ist.

17. Aufbau bzw. Struktur nach Anspruch 14, wobei die zweite Polysilizium-Schicht (46) und ein Abschnitt der ersten Polysilizium-Schicht (40, 42) vom p-Typ in physikalischem Kontakt sind und mit einem Typ P+ dotiert sind.

## Revendications

1. Méthode pour produire une structure à semi-conducteurs avec des dispositifs de charge polycristallins à canal p d'un circuit intégré comprenant les étapes consistant à : réaliser un premier dispositif à effet de champ à canal n (14) ; réaliser une première couche isolante (34) disposée sur le dispositif à effet de champ à canal n, avec une ouverture pour exposer une structure conductrice sous-jacente comprenant au moins une portion d'une région source/drain de type n dudit dispositif à effet de champ à canal n ; réaliser une couche de contact (35, 36) sur la structure conductrice sous-jacente exposée définissant une portion d'une région de contact partagée, ladite couche de contact faisant un contact électrique avec ladite région source/drain (22) dudit dispositif à effet de champ à canal n ; réaliser une première couche de polysilicium de type p (40, 42) comprenant une première électrode de porte (42) d'un premier dispositif à effet de champ à canal p disposé sur une portion de la première couche isolante (34) ; réaliser une première couche d'oxyde de porte (44) ; et réaliser une seconde couche de polysilicium (46), comprenant la région source/drain et la région canal du premier dispositif à effet de champ à canal p, disposées sur la première électrode de porte (42) du premier dispositif à effet de champ à canal p et la couche de contact (35, 36), ladite région source/drain dudit dispositif à canal p ayant une conductivité de type p, **caractérisée en ce que** :
ladite première couche de polysilicium de type p (40, 42) comprend également une région (40) en contact avec ladite couche de contact (35, 36), ladite couche à oxyde de grille (44) étant disposée sur la première électrode de grille (42) du premier dispositif à effet de champ à canal p et ladite région (40) de ladite première couche de polysilicium de type p en contact avec ladite couche de contact (35, 36) ; et **en ce que** la région source/drain du dispositif à canal p établit un contact électrique avec la structure conductrice sous-jacente par ladite région (40) de ladite première couche de polysilicium de type p et ladite couche de contact (35, 36) et dans laquelle ladite couche de contact est formée à partir de matériaux sélectionnés dans le groupe composé de métal ; de siliciure de métal ; de polysilicium de type n recouvert de siliciure de métal ; et de siliciure recouvert de polysilicium de type p.

2. Méthode selon la revendication 1, comprenant en outre, avant l'étape de former la première couche isolante (34) sur un substrat (10), les étapes de :
former une région d'oxyde de champ (12) sur une partie du substrat ;
former des régions sources/drains dans le substrat ;
former la première électrode de grille (18) dudit premier dispositif à effet de champ à canal n (14) sur le substrat et former une seconde électrode de grille (30) d'un second dispositif à effet de champ à canal n (26) sur une partie de la région d'oxyde de champ (12) et le substrat (10) ;
par lesquelles la structure conductrice sous-jacente est formée à partir d'une partie de la région source/drain (22) du premier dispositif à effet de champ à canal n et d'une partie de la seconde électrode de grille (30) du second dispositif à effet de champ à canal n.

3. Méthode selon l'une quelconque des revendications précédentes, comprenant en outre, après l'étape de formation de la couche de contact (35, 36), les étapes de :
former une seconde couche isolante (38) sur le circuit intégré ; et
former et graver la seconde couche isolante (38) pour exposer une partie de la couche de contact (35, 36) ;
dans laquelle en même temps que la première couche de polysilicium de type p est formée et gravée pour définir la première électrode de porte (42) du premier dispositif à effet de champ à canal p, la première couche de polysilicium de type p est également formée et gravée pour définir une seconde électrode de grille (40) d'un second dispositif à effet de champ à canal p.

4. Méthode selon la revendication 3, comprenant en outre l'étape de :
former la couche d'oxyde de grille (44) sur la seconde électrode de porte du second dispositif à effet de champ à canal p en même temps que la couche d'oxyde de grille (44) est formée sur la première électrode de grille (42) du premier dispositif à canal p.

5. Méthode selon l'une quelconque des revendications précédentes dépendant de la revendication 3, dans laquelle la première couche de polysilicium de type p (40, 42) et la partie de la seconde couche de polysilicium (46) en contact avec elle sont dopées avec un dopant de type P+.

6. Méthode selon l'une quelconque des revendications précédentes dépendant de la revendication 2, dans laquelle la région source/drain du premier dispositif à effet de champ à canal n et la seconde électrode de grille du second dispositif à effet de champ à canal n sont dopées avec un dopant de type N+.

7. Méthode selon l'une quelconque des revendications précédentes, dans laquelle le matériau métallique de la couche de contact (36) est un métal réfractaire.

8. Méthode selon l'une quelconque des revendications précédentes, dans laquelle le siliciure de métal de la couche de contact est un siliciure de métal réfractaire.

9. Méthode selon l'une quelconque des revendications précédentes, dans laquelle, dans la couche de contact, la couche de siliciure formée en association avec la couche de polysilicium dopée est un siliciure de métal réfractaire.

10. Méthode selon l'une quelconque des revendications précédentes, dans laquelle ladite étape de former la couche de contact comprend une déposition de métal par crépitement.

11. Structure consistant en une partie d'un circuit intégré à semi-conducteurs comprenant : un premier dispositif à effet de champ à canal n (14) ; une première couche isolante (34) disposée sur le dispositif à effet de champ à canal n avec une ouverture pour exposer une structure conductrice sous-jacente comprenant au moins une portion d'une région source/drain de type n dudit dispositif à effet de champ à canal n ; une couche de contact (35, 36) sur la structure conductrice sous-jacente exposée définissant une portion d'une région de contact partagée, ladite couche de contact faisant un contact électrique avec ladite région source/drain (22) dudit dispositif à effet de champ à canal n ; une première couche de polysilicium de type p (40, 42) comprenant une première électrode de porte (42) d'un premier dispositif à effet de champ à canal p disposé sur une portion de la première couche isolante (34) ; une première couche d'oxyde de grille (44) ; et une seconde couche de polysilicium (46), comprenant la région source/drain et la région canal du premier dispositif à effet de champ à canal p, disposées sur la première électrode de porte (42) du premier dispositif à effet de champ à canal p et la couche de contact (35, 36), ladite région source/drain dudit dispositif à canal p ayant une conductivité de type p, **caractérisée en ce que** :
ladite première couche de polysilicium de type p (40, 42) comprend également une région (40) en contact avec ladite couche de contact (35, 36), ladite couche à oxyde de grille (44) étant disposée sur la première électrode de grille (42) du premier dispositif à effet de champ à canal p et ladite région (40) de ladite première couche de polysilicium de type p en contact avec ladite couche de contact (35, 36) ; et **en ce que** la région source/drain du dispositif à canal p établit un contact électrique avec la structure conductrice sous-jacente par ladite région (40) de ladite première couche de polysilicium de type p et ladite couche de contact (35, 36) et dans laquelle ladite couche de contact est formée à partir de matériaux sélectionnés dans le groupe composé de métal ; de siliciure de métal ; de polysilicium de type n recouvert de siliciure de métal ; et de siliciure recouvert de polysilicium de type p.

12. Structure selon la revendication 11, dans laquelle la structure conductrice sous-jacente est la région source/drain (22) du premier dispositif à effet de champ à canal n et une seconde électrode de grille (30) d'un second dispositif à effet de champ à canal n, et dans laquelle ladite région source/drain est dans le substrat et la seconde électrode de porte est disposée sur une région d'oxyde de champ et sur le substrat.

13. Structure selon la revendication 12, dans laquelle la région source/drain (22) du premier dispositif à effet de champ à canal n et la seconde électrode de grille (30) du second dispositif à effet de champ à canal n sont dopées avec un dopant de type N+.

14. Structure selon l'une quelconque des revendications 11 à 13, comprenant en outre :
une seconde couche isolante (38) disposée sur la couche de contact (35, 36) et la première couche isolante (34), ayant une ouverture exposant une partie de la couche de contact (35, 36) ;
la région (40) de ladite première couche de polysilicium de type p comprenant une seconde électrode de grille d'un second dispositif à effet de champ à canal p formé à partir d'une seconde couche de polysilicium de type p dopée, disposée sur la couche de contact (35, 36) et une partie de la seconde couche isolante (38).

15. Structure selon l'une quelconque des revendications 11 à 14, dans laquelle la couche de contact métallique est une couche de métal réfractaire.

16. Structure selon l'une quelconque des revendications 11 à 15, dans laquelle la couche de contact en siliciure de métal est une couche de siliciure de métal réfractaire.

17. Structure selon la revendication 14, dans laquelle la seconde couche de polysilicium (46) et une partie de la première couche de polysilicium de type p (40, 42) sont en contact physique et sont dopées par un dopant de type P+.
